# EUROPEAN PATENT APPLICATION

(11) **EP 4 804 561 A1**
(43) Date of publication of application: **09.09.2026**
(21) Application number: 24885593.4
(22) Date of filing: 24.10.2024
(51) Int. Cl.: H04R 17/00, G01N 29/24, G01N 29/34, G10K 11/30, G10K 11/36, H03H 9/25

(54) **SURFACE ACOUSTIC WAVE DEVICE**

(30) Priority: 01.11.2023 JP 2023187912
(71) Applicant: Niterra Co., Ltd., Nagoya-shi, Aichi 461-0005 (JP); The University of Tokyo, Bunkyo-ku, Tokyo 113-8654 (JP)
(72) Inventor: ITOH Shinsuke, Nagoya-shi, Aichi 461-0005 (JP); KASASHIMA Takashi, Nagoya-shi, Aichi 461-0005 (JP); SUZUKI Ryo, Nagoya-shi, Aichi 461-0005 (JP); MORITA Takeshi, Tokyo 113-8654 (JP); YAMADA Kyohei, Tokyo 113-8654 (JP)
(74) Representative: Grünecker Patent- und Rechtsanwälte PartG mbB
(86) International application number: PCT/JP2024/037976
(87) International publication number: WO 2025/094820

(57) **Abstract**

A surface acoustic wave device (10) includes an ultrasonic wave source (11), a reflection section (12), and a surface wave generation section (13). The reflection section (12) has a reflection surface (20) at which ultrasonic waves generated from the ultrasonic wave source (11) are reflected to generate shear waves. The surface wave generation section (13) generates a surface acoustic wave at a target surface (30) in response to the shear waves generated at the reflection surface (20) being introduced to the target surface (30). The reflection surface (20) is curved such that the shear waves generated at the reflection surface (20) converge at a focal point. When a flat area at a proximal end portion of the target surface (30) in a propagation direction of the surface acoustic wave is defined as a proximal end surface (31), the reflection surface (20) and the proximal end surface (31) are arranged in such a positional relationship that an angle formed between a direction in which at least a portion of the shear waves generated at the reflection surface (20) travels and a traveling direction (TD1) in which the surface acoustic wave travels along the proximal end surface (31) falls within a range of 0° or greater and less than 90°.

## Description

### TECHNICAL FIELD

The present disclosure relates to a surface acoustic wave device.

### BACKGROUND ART

Patent Document 1 discloses an ultrasonic vibrator that generates a surface acoustic wave. Devices that generate a surface acoustic wave are expected to be applied to actuators, atomizing apparatuses, sensors, cell culture apparatuses, microchannel devices, motors that move a driving body, etc.

### PRIOR ART DOCUMENT

### PATENT DOCUMENT

Patent Document 1: Japanese Patent Application Laid-Open (*kokai*) No. H7-222286

### SUMMARY OF THE INVENTION

### PROBLEM TO BE SOLVED BY THE INVENTION

The technology in Patent Document 1 does not take into consideration how to make it easier to generate a surface acoustic wave and has room for improvement in this respect.

An object of the present disclosure is to provide a technology that makes it easier to generate a surface acoustic wave.

### MEANS FOR SOLVING THE PROBLEM

A surface acoustic wave device according to the present disclosure is a surface acoustic wave device including:
an ultrasonic wave source that generates ultrasonic waves;
a reflection section that has a reflection surface at which the ultrasonic waves generated from the ultrasonic wave source are reflected to generate shear waves; and
a surface wave generation section that has a target surface at which a surface acoustic wave is generated in response to the shear waves generated at the reflection surface being introduced to the target surface, wherein
the reflection surface is curved such that the shear waves generated at the reflection surface converge at a focal point, and
when a flat area at a proximal end portion of the target surface in a propagation direction of the surface acoustic wave is defined as a proximal end surface, the reflection surface and the proximal end surface are arranged in such a positional relationship that an angle formed between a direction in which at least a portion of the shear waves generated at the reflection surface travels and a traveling direction in which the surface acoustic wave travels along the proximal end surface falls within a range of 0° or greater and less than 90°.

### ADVANTAGEOUS EFFECTS OF THE INVENTION

The present disclosure can provide a technology that makes it easier to generate a surface acoustic wave.

### BRIEF DESCRIPTION OF THE DRAWINGS

[Fig. 1] Fig. 1 is a perspective view of a surface acoustic wave device according to a first embodiment.
[Fig. 2] Fig. 2 is a cross-sectional view of the surface acoustic wave device according to the first embodiment.
[Fig. 3] Fig. 3 is an explanatory diagram conceptually illustrating a state where ultrasonic waves are propagated.
[Fig. 4] Fig. 4 is a graph representing the relationship between an incident angle and an energy conversion ratio from a longitudinal wave to a shear wave.
[Fig. 5] Fig. 5 is a cross-sectional view of a surface acoustic wave device according to a second embodiment.
[Fig. 6] Fig. 6 is a cross-sectional view of a surface acoustic wave device according to a third embodiment.
[Fig. 7] Fig. 7 is a cross-sectional view of a surface acoustic wave device according to a fourth embodiment.
[Fig. 8] Fig. 8 is a cross-sectional view taken along a line A-A in Fig. 7.
[Fig. 9] Fig. 9 is a cross-sectional view of a surface acoustic wave device according to a fifth embodiment.
[Fig. 10] Fig. 10 is a cross-sectional view of a surface acoustic wave device according to a sixth embodiment.
[Fig. 11] Fig. 11 is a cross-sectional view of a surface acoustic wave device according to a seventh embodiment.
[Fig. 12] Fig. 12 is a plan view of a surface acoustic wave device according to the seventh embodiment.
[Fig. 13] Fig. 13 is a cross-sectional view of a surface acoustic wave device according to an eighth embodiment.
[Fig. 14] Fig. 14 is a cross-sectional view of a surface acoustic wave device according to a ninth embodiment.
[Fig. 15] Fig. 15 is a cross-sectional view of a surface acoustic wave device according to a tenth embodiment.

### MODES FOR CARRYING OUT THE INVENTION

### [Explanation of Embodiments according to Present Disclosure]

The following illustrates an example of a list of embodiments according to the present disclosure.
[1] A surface acoustic wave device including:
   an ultrasonic wave source that generates ultrasonic waves;
   a reflection section that has a reflection surface at which the ultrasonic waves generated from the ultrasonic wave source are reflected to generate shear waves; and
   a surface wave generation section that has a target surface at which a surface acoustic wave is generated in response to the shear waves generated at the reflection surface being introduced to the target surface, in which
   the reflection surface is curved such that the shear waves generated at the reflection surface converge at a focal point, and
   when a flat area at a proximal end portion of the target surface in a propagation direction of the surface acoustic wave is defined as a proximal end surface, the reflection surface and the proximal end surface are arranged in such a positional relationship that an angle formed between a direction in which at least a portion of the shear waves generated at the reflection surface travels and a traveling direction in which the surface acoustic wave travels along the proximal end surface falls within a range of 0° or greater and less than 90°.

In the surface acoustic wave device, the shear waves generated at the reflection surface converge toward the focal point. Moreover, the angle formed between the direction in which at least a portion of the shear waves travels and the traveling direction falls within the range of 0° or greater and less than 90°. Because of this, the shear waves generated at various locations of the reflection surface act intensively on the target surface, thereby generating the surface acoustic wave at the target surface. That is, the surface acoustic wave device easily generates the surface acoustic wave.

[2] The surface acoustic wave device according to [1], wherein
the focal point is positioned between the reflection surface and the proximal end surface in a direction parallel to the proximal end surface, and
in the direction parallel to the proximal end surface, a shortest distance between the focal point and the proximal end surface is shorter than a shortest distance between the focal point and the reflection surface.

With this configuration, the shear waves generated at the reflection surface are likely to concentrate near the proximal end surface, and accordingly, the surface acoustic wave can be generated more easily.

[3] The surface acoustic wave device according to [1] or [2], wherein a portion of the target surface is at the same height position as a highest point of the reflection section in a height direction orthogonal to the proximal end surface or is higher than the highest point of the reflection section.

With this configuration, when processing such as polishing is performed on the above-described portion, the reflection section is unlikely to hinder the processing, thereby facilitating processing of the portion.

[4] The surface acoustic wave device according to any one of [1] to [3], wherein a cross-sectional shape of the target surface taken along the traveling direction has a curved target surface which is curved.

With this configuration, it is possible to change the traveling direction of the surface acoustic wave.

[5] The surface acoustic wave device according to any one of [1] to [4], further including a suppression section that has suppression surfaces arranged on both sides of the target surface in a direction orthogonal to the traveling direction, wherein
the suppression surfaces are continuous with the target surface and are curved such that height positions of the suppression surfaces relative to the target surface become lower as a distance from the target surface increases.

With this configuration, the suppression surfaces can suppress leakage of the surface acoustic wave from the target surface toward both sides. As a result, the propagation efficiency of the surface acoustic wave can be increased.

[6] The surface acoustic wave device according to any one of [1] to [5], wherein the ultrasonic wave source generates longitudinal ultrasonic waves.

With this configuration, ultrasonic waves with higher energy can be generated compared to a configuration in which an ultrasonic wave generating device generates shear waves.

[7] The surface acoustic wave device according to any one of [1] to [6], wherein the reflection surface and the proximal end surface are arranged in such a positional relationship that an angle formed between the direction in which at least a portion of the shear waves generated at the reflection surface travels and the traveling direction falls within a range of 30° or greater and 80° or less.

With this configuration, a surface acoustic wave can be more easily generated on the target surface.

[8] The surface acoustic wave device according to any one of [1] to [7], wherein the reflection surface and the proximal end surface are arranged in such a positional relationship that the shear waves generated at the reflection surface converge at the focal point from both sides in a direction orthogonal to the proximal end surface.

In a configuration in which shear waves converge at a focal point only from one side, the shear waves may pass through the focal point and be reflected near the proximal end surface, which may reduce the efficiency of formation of the surface acoustic wave. Since the shear waves converge at the focal point from both sides in the surface acoustic wave device, the above problem is unlikely to occur due to the interaction of the shear waves that converge from both sides. As a result, the surface acoustic wave can be formed with high efficiency.

[9] The surface acoustic wave device according to any one of [1] to [8], further including a vibration absorber provided at a distal end portion of the surface wave generation section in the propagation direction of the surface acoustic wave.

With this configuration, the vibration absorber can absorb the surface acoustic wave propagated to the distal end portion of the surface wave generation section in the propagation direction of the surface acoustic wave. Accordingly, reflection of the surface acoustic wave at the distal end portion is suppressed, and interference of a surface acoustic wave reflected at the distal end portion with the surface acoustic wave propagated from the proximal end portion side is suppressed.

[10] The surface acoustic wave device according to any one of [1] to [9], wherein
the reflection section has an annular shape,
the ultrasonic wave source is disposed annularly along the reflection section, and
the target surface is disposed on an inner side relative to an inner periphery of the reflection section.

With this configuration, shear waves for generating the surface acoustic waves at the target surface can be generated over the entire circumferential direction. This makes it even easier to generate the surface acoustic waves.

### [Details of Embodiments according to Present Disclosure]

The surface acoustic wave device according to the present disclosure is used in, for example, an atomizing apparatus, an actuator, a sensor, a cell culture apparatus, and a microchannel device.

### <First Embodiment>

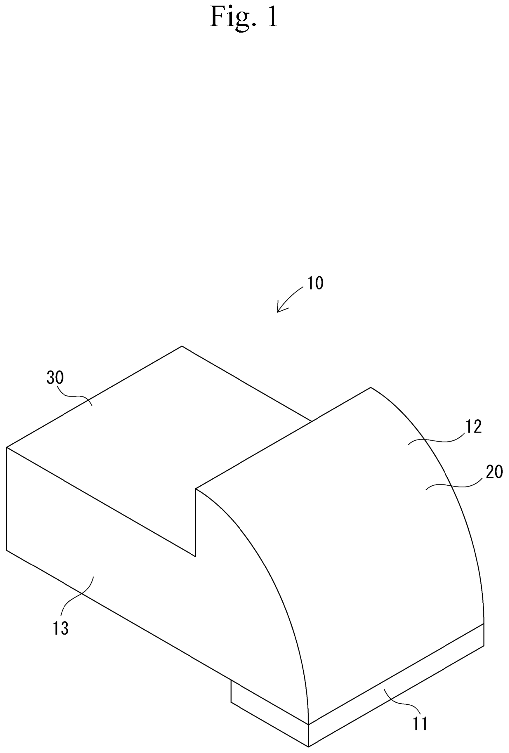

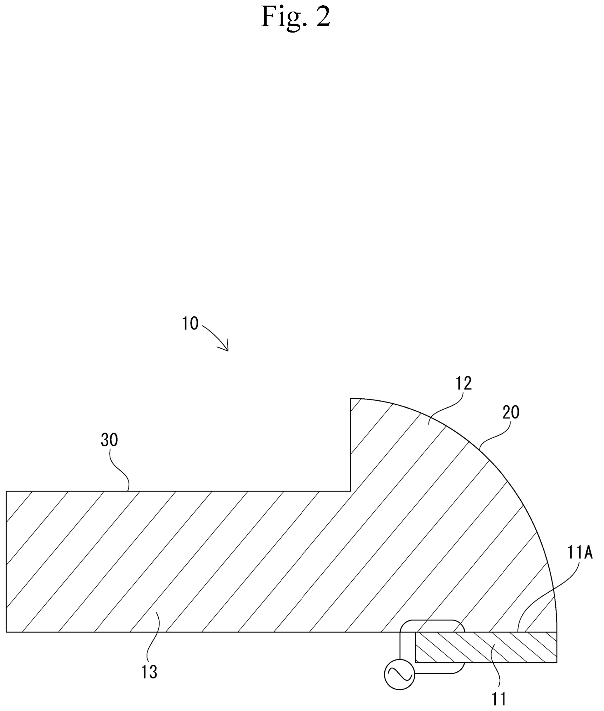

Figs. 1 and 2 disclose a surface acoustic wave device 10. The surface acoustic wave device 10 generates a surface acoustic wave. The surface acoustic wave device 10 includes an ultrasonic wave source 11, a reflection section 12, and a surface wave generation section 13.

The ultrasonic wave source 11 generates ultrasonic waves. The ultrasonic wave source 11 is composed of, for example, a piezoelectric element. The piezoelectric element includes: a piezoelectric body made of piezoelectric ceramics; and electrodes arranged on both sides of the piezoelectric body. The piezoelectric body is made of, for example, lead zirconate titanate (PZT), potassium sodium niobate (KNN), or the like. The ultrasonic wave source 11 has a plate shape. The ultrasonic wave source 11 has a thickness. The thickness direction of the ultrasonic wave source 11 is the stacking direction of the piezoelectric body and the electrodes. The ultrasonic wave source 11 generates ultrasonic waves when an electric signal is supplied thereto from a signal transmitting/receiving circuit (not shown). The ultrasonic wave source 11 generates ultrasonic waves at a frequency of 30 kHz or greater and 100 MHz or less, for example. The ultrasonic wave source 11 generates ultrasonic waves in its thickness direction. In the present embodiment, the ultrasonic wave source 11 generates longitudinal ultrasonic waves.

The reflection section 12 is formed of, for example, a metal (e.g., duralumin). The reflection section 12 has a reflection surface 20. When longitudinal waves generated from the ultrasonic wave source 11 are reflected at the reflection surface 20, longitudinal waves and shear waves are generated. The reflection angles of the longitudinal waves generated at the reflection surface 20 are the same as the incident angles of the longitudinal waves incident on the reflection surface 20. The reflection angles of the shear waves generated at the reflection surface 20 are smaller than the incident angles at the reflection surface 20. The shear waves generated at the reflection surface 20 travel toward the surface wave generation section 13.

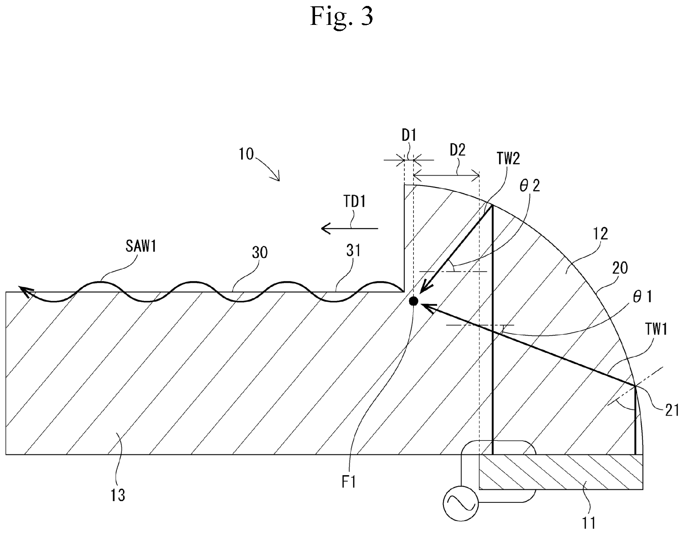

As shown in Fig. 3, the reflection surface 20 is curved such that the shear waves generated at the reflection surface 20 converge at a focal point F1. For example, the reflection surface 20 is shaped along an ellipse, and the ratio between the major axis and minor axis of the ellipse satisfies the condition of the following Formula (1).$Major axis : minor axis = CD : √ \left({CD}^{2}-{CT}^{2}\right)$

CD is the propagation speed of the longitudinal waves incident on the reflection surface 20.

CT is the propagation speed of the shear waves generated at the reflection surface 20.

This configuration causes the shear waves generated at the reflection surface 20 to converge at the focal point F1.

The surface wave generation section 13 is formed of, for example, a metal (e.g., duralumin). The surface wave generation section 13 may be integrated with or separate from the reflection section 12. The surface wave generation section 13 has a target surface 30. The target surface 30 is a flat surface. The target surface 30 is oriented in the same direction as an emission surface 11A of the ultrasonic wave source 11 that emits ultrasonic waves. The surface wave generation section 13 generates a surface acoustic wave at the target surface 30 in response to the shear waves generated at the reflection surface 20 being introduced to the target surface 30.

The target surface 30 has a proximal end surface 31. The proximal end surface 31 is a flat surface positioned at a proximal end portion of the target surface 30 in the propagation direction of the surface acoustic wave. The reflection surface 20 and the proximal end surface 31 are arranged in such a positional relationship that angles formed between directions in which the shear waves generated at the reflection surface 20 travel and a traveling direction TD1 in which the surface acoustic wave travels along the proximal end surface 31 each fall within a range of 0° or greater and less than 90°.

In a case where the proximal end portion of the target surface 30 in the propagation direction of a surface acoustic wave is rounded, the rounded portion is not included in the proximal end surface 31, and a flat surface is defined as the proximal end surface 31.

In the example shown in Fig. 3, an angle θ1 formed between a direction in which a shear wave TW1 generated at the reflection surface 20 travels and the traveling direction TD1 falls within a range of 0° or greater and less than 90°. In addition, an angle θ2 formed between a direction in which a shear wave TW2 generated at the reflection surface 20 travels and the traveling direction TD1 falls within a range of 0° or greater and less than 90°.

As described above, the shear waves generated at various locations of the reflection surface 20 act intensively on the target surface 30, thereby generating a surface acoustic wave SAW1 at the target surface 30. That is, the surface acoustic wave device 10 easily generates the surface acoustic wave SAW1. In particular, the angle θ2 falls within a range of 30° or greater and 80° or less. Accordingly, the surface acoustic wave SAW1 can be more easily generated on the target surface 30 by the shear wave TW2.

The focal point F1 is positioned between the reflection surface 20 and the proximal end surface 31 in a direction parallel to the proximal end surface 31. In the direction parallel to the proximal end surface 31, a shortest distance D1 between the focal point F1 and the proximal end surface 31 is shorter than a shortest distance D2 between the focal point F1 and the reflection surface 20 (see Fig. 3). With this configuration, the shear waves generated at the reflection surface 20 are likely to concentrate near the proximal end surface 31, and accordingly, a surface acoustic wave is generated more easily. Preferably, the shortest distance D1 between the focal point F1 and the proximal end surface 31 is equal to or shorter than 20% of the shortest distance D2 between the focal point F1 and the reflection surface 20.

The shortest distance D2 between the focal point F1 and the reflection surface 20 is preferably equal to or less than one wavelength of the shear waves which converge at the focal point F1.

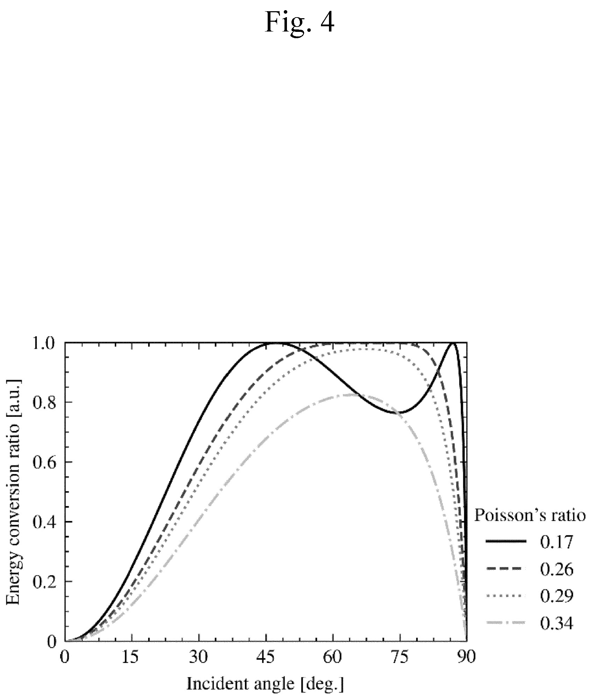

The reflection surface 20 includes a reflection point 21 at which an energy conversion ratio from a longitudinal wave to a shear wave is 50% or greater (see Fig. 3). As shown in Fig. 4, the energy conversion ratio varies depending on the Poisson's ratio of a member forming the reflection surface 20. For example, in a case where the Poisson's ratio is 0.17 or greater and 0.34 or less, at a reflection point (for example, the reflection point 21) where an incident angle of a longitudinal wave generated by the ultrasonic wave source 11 is 40° or greater and 85° or less, the energy conversion ratio from the longitudinal wave to the shear wave is 50% or greater. As a result, the conversion efficiency for converting the longitudinal wave generated by the ultrasonic wave source 11 into the shear wave can be increased easily. From the viewpoint of further improving the energy conversion ratio, it is more preferable that the incident angle of the longitudinal wave is 50° or greater.

The reflection surface 20 and the proximal end surface 31 are arranged in such a positional relationship that shear waves (e.g., the shear waves TW1 and TW2) generated at the reflection surface 20 converge at the focal point F1 from both sides in a direction orthogonal to the proximal end surface 31. In a configuration in which shear waves converge at a focal point only from one side, the shear waves may pass through the focal point and be reflected near the proximal end surface 31, which may reduce the efficiency of formation of a surface acoustic wave. Since shear waves converge at the focal point F1 from both sides in the surface acoustic wave device 10, the above problem is unlikely to occur due to the interaction of the shear waves that converge from both sides. As a result, the surface acoustic wave can be formed with high efficiency.

The ultrasonic wave source 11, the reflection section 12, and the surface wave generation section 13 are each continuously arranged over a wide range in an orthogonal direction orthogonal to a direction in which the ultrasonic wave source 11 generates ultrasonic waves (in a direction orthogonal to the cross-sectional surface in Fig. 2). This makes it possible for the surface acoustic wave device 10 to generate a surface acoustic wave over a wide range in the orthogonal direction.

### <Second Embodiment>

In the first embodiment, an example in which the ultrasonic wave source generates longitudinal waves has been described. In contrast, in a second embodiment, an example in which an ultrasonic wave source generates shear waves will be described.

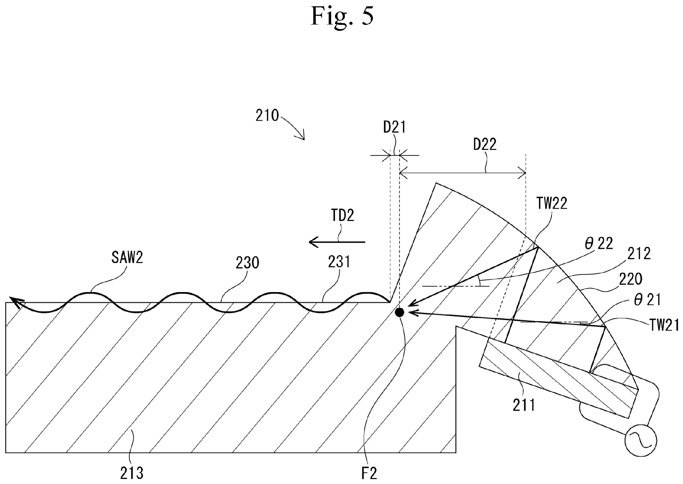

As shown in Fig. 5, a surface acoustic wave device 210 according to the second embodiment includes an ultrasonic wave source 211, a reflection section 212, and a surface wave generation section 213. The ultrasonic wave source 211, the reflection section 212, and the surface wave generation section 213 are each continuously arranged over a wide range in an orthogonal direction orthogonal to a direction in which the ultrasonic wave source 211 generates ultrasonic waves (in a direction orthogonal to the cross-sectional surface in Fig. 5).

The ultrasonic wave source 211 generates shear ultrasonic waves. In other respects, the ultrasonic wave source 211 is the same as the ultrasonic wave source 11 according to the first embodiment.

The reflection section 212 is formed of, for example, a metal (e.g., duralumin). The reflection section 212 has a reflection surface 220. When the shear waves generated from the ultrasonic wave source 211 are reflected at the reflection surface 220, longitudinal waves and shear waves are generated. The reflection angles of the shear waves generated at the reflection surface 220 are the same as the incident angles of the shear waves incident on the reflection surface 220. The shear waves generated at the reflection surface 220 travel toward the surface wave generation section 213.

The reflection surface 220 is curved such that the shear waves generated at the reflection surface 220 converge at a focal point F2. For example, the reflection surface 220 is a parabolic surface.

The surface wave generation section 213 is formed of, for example, a metal (e.g., duralumin). The surface wave generation section 213 may be integrated with or separate from the reflection section 212. The surface wave generation section 213 has a target surface 230. The target surface 230 is a flat surface. The surface wave generation section 213 generates a surface acoustic wave at the target surface 230 in response to the shear waves generated at the reflection surface 220 being introduced to the target surface 230.

The target surface 230 has a proximal end surface 231. The proximal end surface 231 is a flat surface positioned at a proximal end portion of the target surface 230 in the propagation direction of the surface acoustic wave. The reflection surface 220 and the proximal end surface 231 are arranged in such a positional relationship that angles formed between directions in which the shear waves generated at the reflection surface 220 travel and a traveling direction TD2 in which the surface acoustic wave travels along the proximal end surface 231 each fall within a range of 0° or greater and less than 90°.

In the example shown in Fig. 5, an angle θ21 formed between a direction in which a shear wave TW21 generated at the reflection surface 220 travels and the traveling direction TD2 falls within a range of 0° or greater and less than 90°. In addition, an angle θ22 formed between a direction in which a shear wave TW22 generated at the reflection surface 220 travels and the traveling direction TD2 falls within a range of 0° or greater and less than 90°.

As described above, the shear waves generated at various locations of the reflection surface 220 act intensively on the target surface 230, thereby generating a surface acoustic wave SAW2 at the target surface 230. That is, the surface acoustic wave device 210 easily generates the surface acoustic wave SAW2.

The focal point F2 is positioned between the reflection surface 220 and the proximal end surface 231 in a direction parallel to the proximal end surface 231. In the direction parallel to the proximal end surface 231, a shortest distance D21 between the focal point F2 and the proximal end surface 231 is shorter than a shortest distance D22 between the focal point F2 and the reflection surface 220. With this configuration, the shear waves generated at the reflection surface 220 are likely to concentrate near the proximal end surface 231, and accordingly, a surface acoustic wave is generated more easily. Preferably, the shortest distance D21 between the focal point F2 and the proximal end surface 231 is equal to or shorter than 20% of the shortest distance D22 between the focal point F2 and the reflection surface 220.

### <Third Embodiment>

In the first embodiment, an example in which the target surface is entirely flat has been described. In contrast, in a third embodiment, an example in which a target surface has a curved target surface curved in a direction in which a surface acoustic wave travels will be described. In the third embodiment, components that are the same as those in the first embodiment are denoted by the same reference numerals, and the detailed description thereof is omitted.

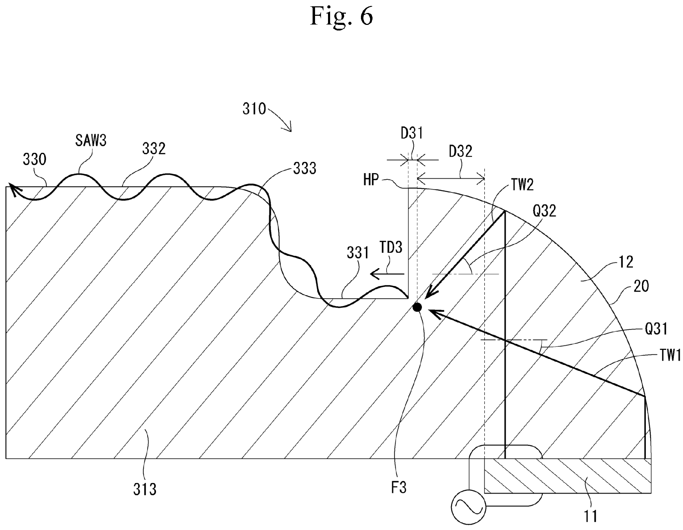

As shown in Fig. 6, a surface acoustic wave device 310 according to the third embodiment includes an ultrasonic wave source 11, a reflection section 12, and a surface wave generation section 313. The ultrasonic wave source 11, the reflection section 12, and the surface wave generation section 313 are each continuously arranged over a wide range in an orthogonal direction orthogonal to a direction in which the ultrasonic wave source 11 generates ultrasonic waves (in a direction orthogonal to the cross-sectional surface in Fig. 6).

The surface wave generation section 313 is formed of, for example, a metal (e.g., duralumin). The surface wave generation section 313 may be integrated with or separate from the reflection section 12. The surface wave generation section 313 has a target surface 330. The surface wave generation section 313 generates a surface acoustic wave at the target surface 330 in response to shear waves generated at the reflection surface 20 being introduced to the target surface 330.

The target surface 330 has a proximal end surface 331, a flat target surface 332, and a curved target surface 333. The proximal end surface 331 is a flat surface positioned at a proximal end portion of the target surface 330 in the propagation direction of the surface acoustic wave. The reflection surface 20 and the proximal end surface 331 are arranged in such a positional relationship that angles formed between directions in which the shear waves generated at the reflection surface 20 travel and a traveling direction TD3 in which the surface acoustic wave travels along the proximal end surface 331 each fall within a range of 0° or greater and less than 90°.

In the example shown in Fig. 6, an angle θ31 formed between a direction in which a shear wave TW1 generated at the reflection surface 20 travels and the traveling direction TD3 falls within a range of 0° or greater and less than 90°. In addition, an angle θ32 formed between a direction in which a shear wave TW2 generated at the reflection surface 20 travels and the traveling direction TD3 falls within a range of 0° or greater and less than 90°.

As described above, the shear waves generated at various locations of the reflection surface 20 act intensively on the target surface 330, thereby generating a surface acoustic wave SAW3 at the target surface 330. That is, the surface acoustic wave device 310 easily generates the surface acoustic wave SAW3. In particular, the angle θ32 falls within a range of 30° or greater and 80° or less. Accordingly, the surface acoustic wave SAW3 can be more easily generated on the target surface 30 by the shear wave TW2.

The focal point F3 is positioned between the reflection surface 20 and the proximal end surface 331 in a direction parallel to the proximal end surface 331. In the direction parallel to the proximal end surface 331, a shortest distance D31 between the focal point F3 and the proximal end surface 331 is shorter than a shortest distance D32 between the focal point F3 and the reflection surface 20. With this configuration, the shear waves generated at the reflection surface 20 are likely to concentrate near the proximal end surface 331, and accordingly, a surface acoustic wave is generated more easily. Preferably, the shortest distance D31 between the focal point F3 and the proximal end surface 331 is equal to or shorter than 20% of the shortest distance D32 between the focal point F3 and the reflection surface 20.

The flat target surface 332 is disposed on the distal end side in the propagation direction of the surface acoustic wave with respect to the proximal end surface 331. The flat target surface 332 is provided at a distal end portion of the target surface 330 in the propagation direction of the surface acoustic wave. The flat target surface 332 is a flat surface. In the height direction orthogonal to the proximal end surface 331, the flat target surface 332 is disposed at the same height position as a highest point HP of the reflection section 12. With this configuration, when processing such as polishing is performed on the flat target surface 332, the reflection section 12 is unlikely to hinder the processing, thereby facilitating processing of the flat target surface 332.

The curved target surface 333 is disposed on the distal end side in the propagation direction of the surface acoustic wave with respect to the proximal end surface 331. The curved target surface 333 is disposed between the proximal end surface 331 and the flat target surface 332 in the propagation direction of the surface acoustic wave. The curved target surface 333 has a curved cross-sectional shape taken along the direction in which the surface acoustic wave travels. With this configuration, it is possible to change a direction in which the surface acoustic wave travels along the target surface 330.

### <Fourth Embodiment>

In a fourth embodiment, an example in which suppression surfaces are arranged on both sides of a target surface will be described. In the fourth embodiment, components that are the same as those in the first embodiment are denoted by the same reference numerals, and the detailed description thereof is omitted.

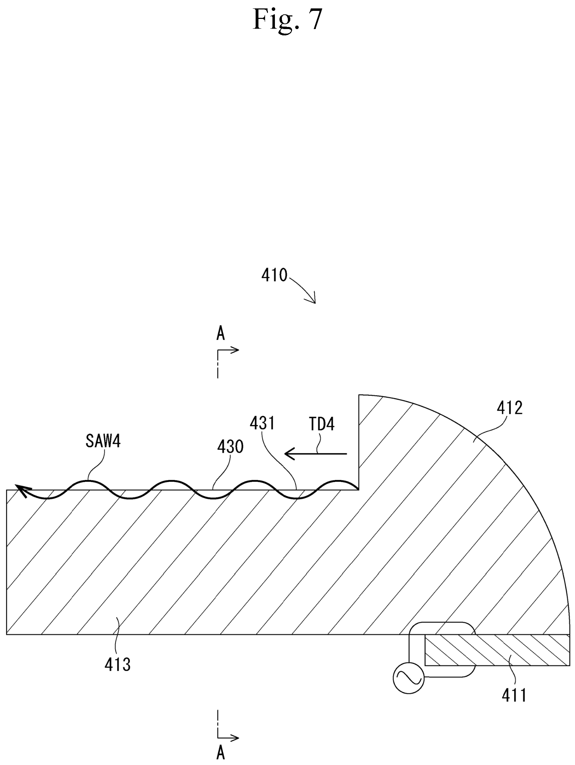

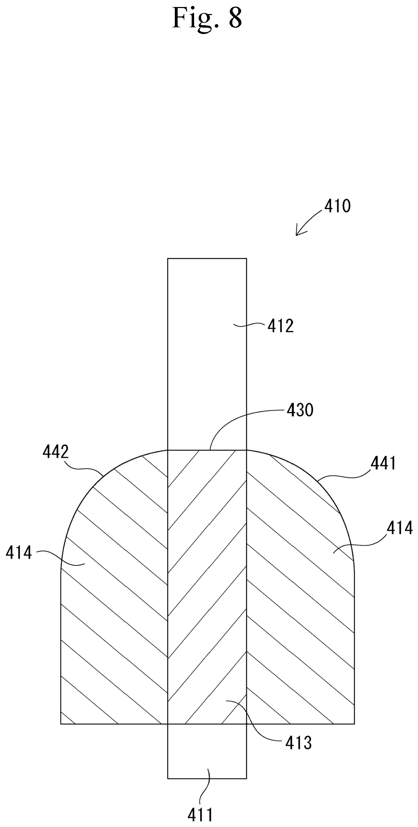

As shown in Figs. 7 and 8, a surface acoustic wave device 410 according to the fourth embodiment includes an ultrasonic wave source 411, a reflection section 412, and a surface wave generation section 413. The ultrasonic wave source 411, the reflection section 412, and the surface wave generation section 413 are different from the ultrasonic wave source 11, the reflection section 12, and the surface wave generation section 13 according to the first embodiment in that the lengths of the ultrasonic wave source 411, the reflection section 412, and the surface wave generation section 413 in the depth direction (an orthogonal direction orthogonal to the direction in which the ultrasonic wave source 11 generates ultrasonic waves) are shorter, and the ultrasonic wave source 411, the reflection section 412, and the surface wave generation section 413 are the same as the ultrasonic wave source 11, the reflection section 12, and the surface wave generation section 13 in other respects.

The surface wave generation section 413 has a target surface 430. The target surface 430 is a flat surface. The target surface 430 has a proximal end surface 431. The proximal end surface 431 is a flat surface positioned at a proximal end portion of the target surface 430 in the propagation direction of a surface acoustic wave.

The surface acoustic wave device 410 further includes a suppression section 414. The suppression section 414 has suppression surfaces 441 and 442. The suppression surfaces 441 and 442 are arranged on both sides of the target surface 430 of the surface wave generation section 413 in a direction orthogonal to a traveling direction TD4 in which the surface acoustic wave travels along the proximal end surface 431. The suppression surfaces 441 and 442 are continuous with the target surface 430 and are curved such that the height positions of the suppression surfaces 441 and 442 relative to the target surface 430 become lower as a distance from the target surface 430 increases. A surface acoustic wave SAW4 is unlikely to propagate on a surface that is curved in the direction orthogonal to the traveling direction TD4. That is, with this configuration, the suppression surfaces 441 and 442 can suppress leakage of the surface acoustic wave SAW4 from the target surface 430 toward both sides. As a result, the propagation efficiency of the surface acoustic wave SAW4 can be increased.

### <Fifth Embodiment>

In a fifth embodiment, a configuration including a vibration absorber will be described. In the fifth embodiment, components that are the same as those in the first embodiment are denoted by the same reference numerals, and the detailed description thereof is omitted.

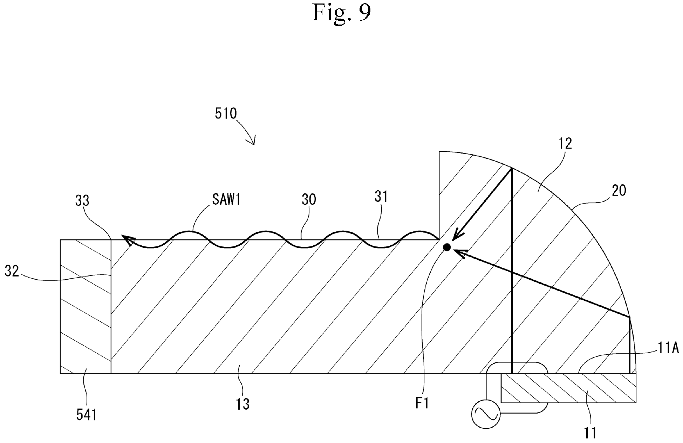

As shown in Fig. 9, a surface acoustic wave device 510 according to the fifth embodiment includes a vibration absorber 541, in addition to the components of the surface acoustic wave device 10 according to the first embodiment. The vibration absorber 541 is formed of a well-known material such as a urethane-based synthetic rubber, for example.

The vibration absorber 541 is provided at a distal end portion of a surface wave generation section 13 in the propagation direction of a surface acoustic wave SAW1. The surface wave generation section 13 has a distal end surface 32 provided at the distal end thereof in the propagation direction of the surface acoustic wave SAW1. The distal end surface 32 is continuous with a target surface 30 via a bent section 33. The vibration absorber 541 is provided at the distal end surface 32.

With this configuration, the vibration absorber 541 can absorb the surface acoustic wave SAW1 propagated to the distal end portion of the surface wave generation section 13 in the propagation direction of the surface acoustic wave SAW1. Accordingly, reflection of the surface acoustic wave SAW1 at the distal end portion is suppressed, and interference of a surface acoustic wave reflected at the distal end portion with the surface acoustic wave SAW1 propagated from the proximal end portion side is suppressed.

### <Sixth Embodiment>

In a sixth embodiment, another example of a configuration including a vibration absorber, which is different from that of the fifth embodiment, will be described. In the sixth embodiment, components that are the same as those in the first embodiment are denoted by the same reference numerals, and the detailed description thereof is omitted.

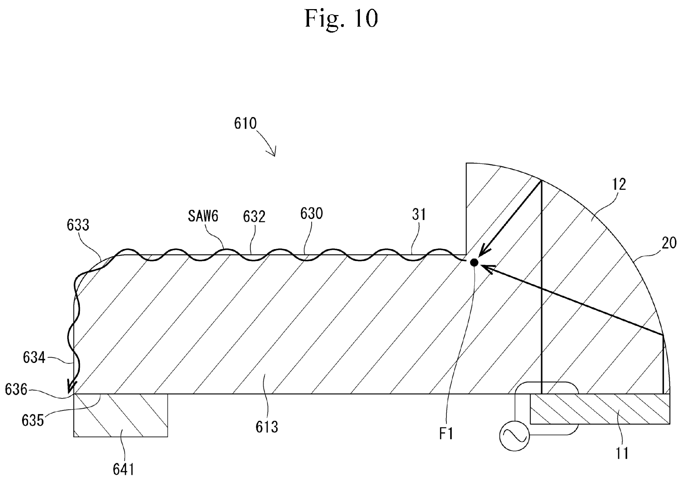

As shown in Fig. 10, a surface acoustic wave device 610 according to the sixth embodiment includes an ultrasonic wave source 11, a reflection section 12, and a surface wave generation section 613. The ultrasonic wave source 11, the reflection section 12, and the surface wave generation section 613 are each continuously arranged over a wide range in an orthogonal direction orthogonal to a direction in which the ultrasonic wave source 11 generates ultrasonic waves (in a direction orthogonal to the cross-sectional surface in Fig. 10).

The surface wave generation section 613 is formed of, for example, a metal (e.g., duralumin). The surface wave generation section 613 may be integrated with or separate from the reflection section 12. The surface wave generation section 613 has a target surface 630. The surface wave generation section 613 generates a surface acoustic wave SAW6 at the target surface 630 in response to shear waves generated at the reflection surface 20 being introduced to the target surface 630.

The target surface 630 has a proximal end surface 31, a first flat target surface 632, a curved target surface 633, and a second flat target surface 634. The proximal end surface 31, the first flat target surface 632, the curved target surface 633, and the second flat target surface 634 are arranged in this order from the proximal end side to the distal end side of the surface wave generation section 613 in the propagation direction of the surface acoustic wave SAW6. The first flat target surface 632 is flush with the proximal end surface 31. The curved target surface 633 is continuous with the first flat target surface 632. The second flat target surface 634 is continuous with the curved target surface 633 and is disposed along a direction orthogonal to the first flat target surface 632.

The surface acoustic wave device 610 includes a vibration absorber 641. The vibration absorber 641 is formed of a well-known material such as a urethane-based synthetic rubber, for example. The vibration absorber 641 is provided at a distal end portion of the surface wave generation section 613 in the propagation direction of the surface acoustic wave SAW6. The surface wave generation section 613 has a distal end surface 635 provided at the distal end thereof in the propagation direction of the surface acoustic wave SAW6. The distal end surface 635 is connected to the target surface 630 via a bent section 636. The vibration absorber 641 is provided at the distal end surface 635.

With this configuration, the vibration absorber 641 can absorb the surface acoustic wave SAW6 propagated to the distal end portion of the surface wave generation section 613 in the propagation direction of the surface acoustic wave SAW6. Accordingly, reflection of the surface acoustic wave SAW6 at the distal end portion is suppressed, and interference of a surface acoustic wave reflected at the distal end portion with the surface acoustic wave SAW6 propagated from the proximal end portion side is suppressed.

### <Seventh Embodiment>

In a seventh embodiment, a surface acoustic wave device having a rotary-body shape will be described. In the seventh embodiment, components that are the same as those in the first embodiment are denoted by the same reference numerals, and the detailed description thereof is omitted.

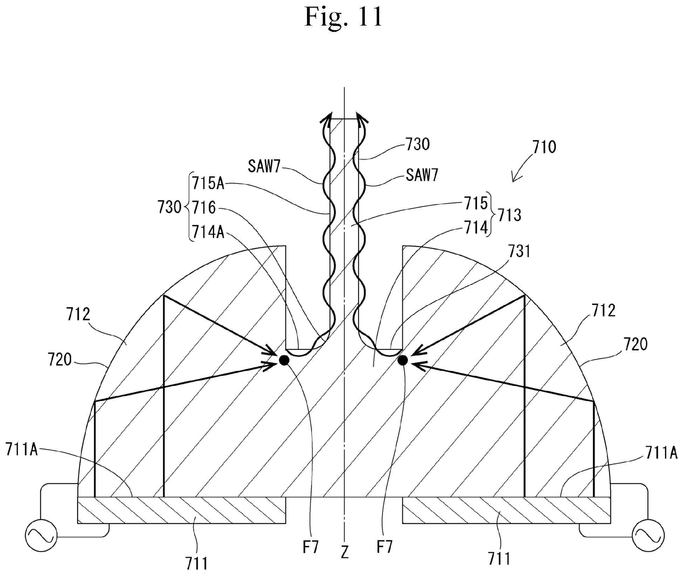

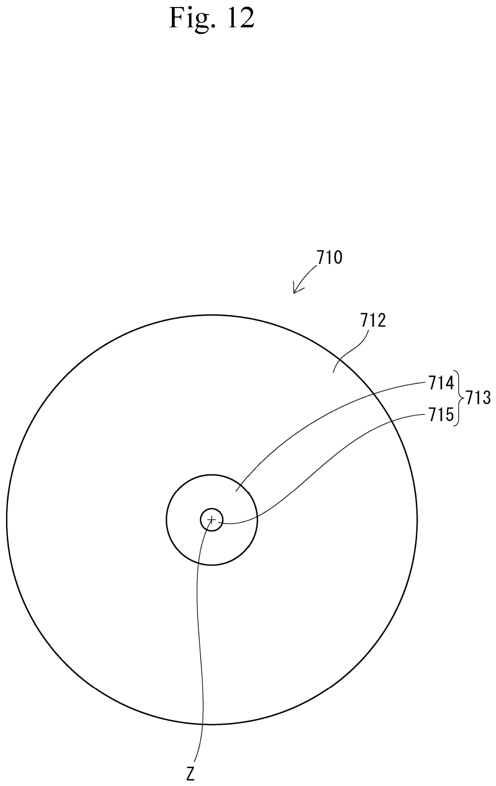

As shown in Figs. 11 and 12, a surface acoustic wave device 710 according to the seventh embodiment includes an ultrasonic wave source 711, a reflection section 712, and a surface wave generation section 713.

The reflection section 712 has an annular shape (more specifically, a circular annular shape) centered on an axis Z. The reflection section 712 has a reflection surface 720. The reflection surface 720 has an annular shape (more specifically, a circular annular shape) centered on the axis Z. The ultrasonic wave source 711 is disposed annularly (more specifically, in a circular annular shape) along the reflection section 712. The ultrasonic wave source 711 has an annular shape (more specifically, a circular annular shape) centered on the axis Z. The surface wave generation section 713 has a target surface 730. The surface wave generation section 713 and the target surface 730 are arranged on the inner side of the annular reflection section 712. That is, the surface wave generation section 713 and the target surface 730 are arranged on the radially inner side of the reflection section 712.

The surface wave generation section 713 has a proximal portion 714 and a shaft portion 715. The proximal portion 714 is continuous with the inner periphery of the annular reflection section 712 over its entire circumference. The proximal portion 714 has a proximal surface 714A. The proximal surface 714A is oriented in the same direction as an emission surface 711A of the ultrasonic wave source 711 that emits ultrasonic waves. The shaft portion 715 has a rod-like shape extending from the proximal surface 714A of the proximal portion 714. The shaft portion 715 extends along the axis Z. The shaft portion 715 protrudes in the direction in which the emission surface 711A is oriented. An outer peripheral surface 715A of the shaft portion 715 is continuous with the proximal surface 714A via a curved target surface 716. The target surface 730 of the surface wave generation section 713 is formed by the proximal surface 714A, the curved target surface 716, and the outer peripheral surface 715A of the shaft portion 715.

When longitudinal waves generated from the ultrasonic wave source 711 are reflected at the reflection surface 720, longitudinal waves and shear waves are generated. Each of shear waves generated over the entire circumference of the reflection surface 720 travels toward the surface wave generation section 713. As shown in Fig. 11, the reflection surface 720 is curved such that the shear waves generated at the reflection surface 720 converge at focal points F7.

The surface wave generation section 713 generates surface acoustic waves SAW7 over the entire circumference of the target surface 730 in response to the shear waves generated over the entire circumference of the reflection surface 720 being introduced to the target surface 730. The target surface 730 (more specifically, the proximal surface 714A) of the surface wave generation section 713 has a proximal end surface 731. The proximal end surface 731 has an annular shape (more specifically, a circular annular shape) centered on the axis Z. The surface acoustic waves SAW7 generated over the entire circumference of the proximal end surface 731 travel radially inward at the proximal surface 714A toward the shaft portion 715, propagate to the outer peripheral surface 715A of the shaft portion 715 via the curved target surface 716, and propagate at the outer peripheral surface 715A of the shaft portion 715 from a proximal end side toward a distal end side of the shaft portion 715.

With this configuration, shear waves for generating the surface acoustic waves SAW7 at the target surface 730 can be generated over the entire circumferential direction. This makes it even easier to generate the surface acoustic waves SAW7.

### <Eighth Embodiment>

In the seventh embodiment, an example in which the surface wave generation section is solid has been described. In contrast, in an eighth embodiment, an example in which a surface wave generation section is tubular will be described. In the eighth embodiment, components that are the same as those in the seventh embodiment are denoted by the same reference numerals, and the detailed description thereof is omitted.

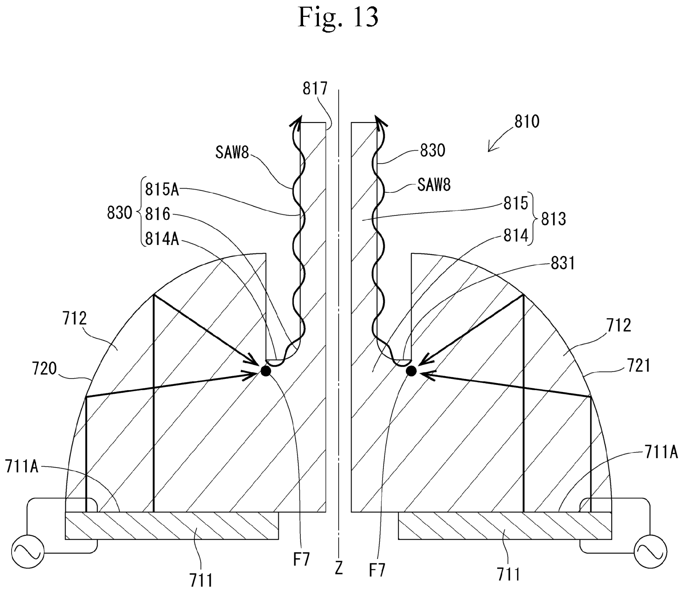

As shown in Fig. 13, a surface acoustic wave device 810 according to the eighth embodiment corresponds to a configuration in which a through hole penetrating the surface wave generation section 713 (more specifically, the proximal portion 714 and the shaft portion 715) along the axis Z is formed in the surface acoustic wave device 710 according to the seventh embodiment.

The surface acoustic wave device 810 includes an ultrasonic wave source 711, a reflection section 712, and a surface wave generation section 813. The surface wave generation section 813 has a tubular shape centered on the axis Z. The surface wave generation section 813 has a proximal portion 814 and a shaft portion 815.

The proximal portion 814 has a tubular shape centered on the axis Z. The proximal portion 814 is continuous with the inner periphery of the annular reflection section 712 over its entire circumference. The proximal portion 814 has a proximal surface 814A. The proximal surface 814A is oriented in the same direction as the emission surface 711A of the ultrasonic wave source 711.

The shaft portion 815 protrudes from the proximal surface 814A of the proximal portion 814 in the direction in which the emission surface 711A is oriented. The shaft portion 815 extends along the axis Z. The shaft portion 815 has a tubular shape centered on the axis Z. The internal space of the shaft portion 815 communicates with the internal space of the proximal portion 814. A through hole 817 penetrating the surface wave generation section 813 (more specifically, the proximal portion 814 and the shaft portion 815) along the axis Z is formed in the surface wave generation section 813. An outer peripheral surface 815A of the shaft portion 815 is continuous with the proximal surface 814A via a curved target surface 816. A target surface 830 of the surface wave generation section 813 is formed by the proximal surface 814A, the curved target surface 816, and the outer peripheral surface 815A of the shaft portion 815.

The surface wave generation section 813 generates surface acoustic waves SAW8 over the entire circumference of the target surface 830 in response to shear waves generated over the entire circumference of the reflection surface 720 being introduced to the target surface 830. The target surface 830 (more specifically, the proximal surface 814A) of the surface wave generation section 813 has a proximal end surface 831. The proximal end surface 831 has an annular shape (more specifically, a circular annular shape) centered on the axis Z. The surface acoustic waves SAW8 generated over the entire circumference of the proximal end surface 831 travel radially inward at the proximal surface 814A toward the shaft portion 815, propagate to the outer peripheral surface 815A of the shaft portion 815 via the curved target surface 816, and propagate at the outer peripheral surface 815A of the shaft portion 815 from a proximal end side toward a distal end side of the shaft portion 815.

In this configuration as well, shear waves for generating the surface acoustic waves SAW8 at the target surface 830 can be generated over the entire circumferential direction. This makes it even easier to generate the surface acoustic waves SAW8.

### <Ninth Embodiment>

In the eighth embodiment, an example in which the outer peripheral surface of the shaft portion is defined as a target surface has been described. In contrast, in a ninth embodiment, an example in which the inner periphery surface of a shaft portion is defined as a target surface will be described. In the ninth embodiment, components that are the same as those in the eighth embodiment are denoted by the same reference numerals, and the detailed description thereof is omitted.

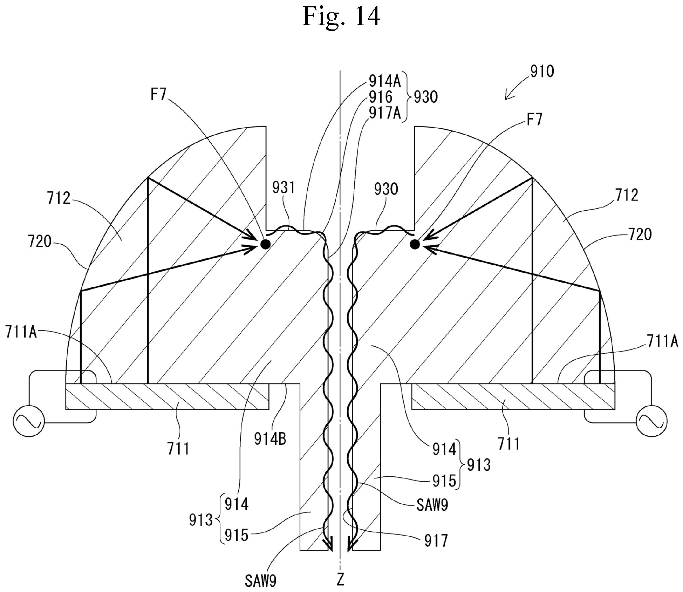

As shown in Fig. 14, a surface acoustic wave device 910 according to the ninth embodiment includes an ultrasonic wave source 711, a reflection section 712, and a surface wave generation section 913.

The surface wave generation section 913 has a tubular shape centered on the axis Z. The surface wave generation section 913 has a proximal portion 914 and a shaft portion 915.

The proximal portion 914 has a tubular shape centered on the axis Z. The proximal portion 914 is continuous with the inner periphery of the annular reflection section 712 over its entire circumference. The proximal portion 914 has a first surface 914A oriented in the same direction as the emission surface 711A of the ultrasonic wave source 711, and a second surface 914B provided on the side opposite to the first surface 914A.

The shaft portion 915 protrudes from the second surface 914B of the proximal portion 914. The shaft portion 915 extends along the axis Z. The shaft portion 915 has a tubular shape centered on the axis Z. The internal space of the shaft portion 915 communicates with the internal space of the proximal portion 914.

A through hole 917 penetrating the surface wave generation section 913 (more specifically, the proximal portion 914 and the shaft portion 915) along the axis Z is formed in the surface wave generation section 913. An inner periphery surface 917A of the through hole 917 is continuous with the first surface 914A with a curved target surface 916 interposed therebetween. A target surface 930 of the surface wave generation section 913 is formed by the first surface 914A, the curved target surface 916, and the inner periphery surface 917A of the through hole 917.

The surface wave generation section 913 generates surface acoustic waves SAW9 over the entire circumference of the target surface 930 in response to shear waves generated over the entire circumference of the reflection surface 720 being introduced to the target surface 930. The target surface 930 (more specifically, the first surface 914A) of the surface wave generation section 913 has a proximal end surface 931. The proximal end surface 931 has an annular shape (more specifically, a circular annular shape) centered on the axis Z. The surface acoustic waves SAW9 generated over the entire circumference of the proximal end surface 931 propagate radially inward at the first surface 914A toward the through hole 917, and propagate at the inner periphery surface 917A of the through hole 917 from a proximal end side toward a distal end side of the shaft portion 915.

With this configuration, the surface acoustic waves SAW9 can be generated at the inner periphery surface 917A of the through hole 917.

### <Tenth Embodiment>

In a tenth embodiment, an example in which a target surface is oriented in a direction opposite to that of an emission surface of an ultrasonic wave source will be described. In the tenth embodiment, components that are the same as those in the first embodiment are denoted by the same reference numerals, and the detailed description thereof is omitted.

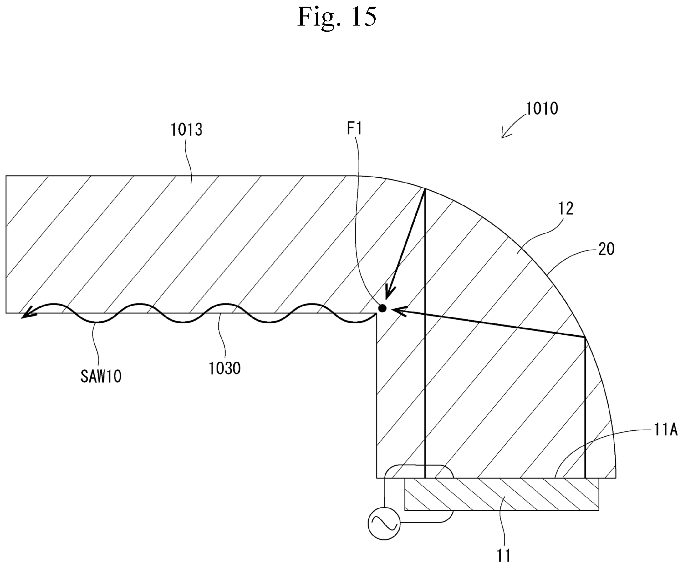

As shown in Fig. 15, a surface acoustic wave device 1010 according to the tenth embodiment includes an ultrasonic wave source 11, a reflection section 12, and a surface wave generation section 1013. The surface wave generation section 1013 has a target surface 1030. The target surface 1030 is oriented in a direction opposite to that of the emission surface 11A of the ultrasonic wave source 11.

With this configuration, a surface acoustic wave SAW10 can be generated at a surface oriented in a direction opposite to that of the emission surface 11A of the ultrasonic wave source 11.

### <Other Embodiments>

The present invention is not limited to the embodiments described above and illustrated in the drawings, and, for example, the following embodiments are also included within the technical scope of the present invention. In addition, various features of the embodiments described above and embodiments described below may be combined in any manner as long as such combinations are not contradictory.
(1) In the configuration of each of the first to third embodiments described above, the ultrasonic wave source, the reflection section, and the surface wave generation section are each continuously arranged in the orthogonal direction orthogonal to the direction in which the ultrasonic wave source generates ultrasonic waves. In contrast, the ultrasonic wave source may be composed of a plurality of members and may be intermittently arranged in the orthogonal direction. The reflection section may be composed of a plurality of members and may be intermittently arranged in the orthogonal direction. The surface wave generation section may be composed of a plurality of members and may be intermittently arranged in the orthogonal direction.
(2) In the configuration of the third embodiment, the flat target surface is disposed at the same height position as the highest point of the reflection section. In contrast, the flat target surface may be disposed at a position higher than the highest point of the reflection section.

The embodiments disclosed herein are illustrative in all aspects and should not be construed as being restrictive. The scope of the present invention is not limited to the embodiments disclosed herein and is intended to encompass all modifications within the scope of the claims or within the scope equivalent to the claims.

### DESCRIPTION OF REFERENCE NUMERALS

10, 210, 310, 410, 510, 610, 710, 810, 910, 1010 ... surface acoustic wave device
11, 211, 411, 711 ... ultrasonic wave source
11A, 711A ... emission surface
12, 212, 412, 712 ... reflection section
13, 213, 313, 413, 613, 713, 813, 913, 1013 ... surface wave generation section
20, 220, 720 ... reflection surface
21 ... reflection point
30, 230, 330, 430, 630, 730, 830, 930, 1030 ... target surface
31, 231, 331, 431, 731, 831, 931 ... proximal end surface
32, 635 ... distal end surface of surface wave generation section
33, 363 ... bent section
332 ... flat target surface
333, 633, 716, 816, 916 ... curved target surface
414 ... suppression section
441, 442 ... suppression surface
541, 641 ... vibration absorber
632 ... first flat target surface
634 ... second flat target surface
714, 814, 914 ... proximal portion
714A, 814A ... proximal surface
715, 815, 915 ... shaft portion
715A, 815A ... outer peripheral surface of shaft portion
817, 917 ... through hole
D1, D2, D21, D22, D31, D32 ... shortest distance
F1, F2, F3, F7 ... focal point
HP ... highest point
SAW1, SAW2, SAW3, SAW4, SAW6, SAW7, SAW8, SAW9, SAW10 ... surface acoustic wave
TD1, TD2, TD3, TD4 ... traveling direction
TW1, TW2, TW21, TW22 ... shear wave
θ1, θ2, θ21, θ22, θ31, θ32 ... angle

## Claims

1. A surface acoustic wave device comprising:
an ultrasonic wave source that generates ultrasonic waves;
a reflection section that has a reflection surface at which the ultrasonic waves generated from the ultrasonic wave source are reflected to generate shear waves; and
a surface wave generation section that has a target surface at which a surface acoustic wave is generated in response to the shear waves generated at the reflection surface being introduced to the target surface, wherein
the reflection surface is curved such that the shear waves generated at the reflection surface converge at a focal point, and
when a flat area at a proximal end portion of the target surface in a propagation direction of the surface acoustic wave is defined as a proximal end surface, the reflection surface and the proximal end surface are arranged in such a positional relationship that an angle formed between a direction in which at least a portion of the shear waves generated at the reflection surface travels and a traveling direction in which the surface acoustic wave travels along the proximal end surface falls within a range of 0° or greater and less than 90°.

2. The surface acoustic wave device according to claim 1, wherein
the focal point is positioned between the reflection surface and the proximal end surface in a direction parallel to the proximal end surface, and
in the direction parallel to the proximal end surface, a shortest distance between the focal point and the proximal end surface is shorter than a shortest distance between the focal point and the reflection surface.

3. The surface acoustic wave device according to claim 1 or 2, wherein a portion of the target surface is at the same height position as a highest point of the reflection section in a height direction orthogonal to the proximal end surface or is higher than the highest point of the reflection section.

4. The surface acoustic wave device according to claim 1 or 2, wherein a cross-sectional shape of the target surface taken along the traveling direction has a curved target surface which is curved.

5. The surface acoustic wave device according to claim 1 or 2, further comprising a suppression section that has suppression surfaces arranged on both sides of the target surface in a direction orthogonal to the traveling direction, wherein
the suppression surfaces are continuous with the target surface and are curved such that height positions of the suppression surfaces relative to the target surface become lower as a distance from the target surface increases.

6. The surface acoustic wave device according to claim 1 or 2, wherein the ultrasonic wave source generates longitudinal ultrasonic waves.

7. The surface acoustic wave device according to claim 1 or 2, wherein the reflection surface and the proximal end surface are arranged in such a positional relationship that an angle formed between the direction in which at least a portion of the shear waves generated at the reflection surface travels and the traveling direction falls within a range of 30° or greater and 80° or less.

8. The surface acoustic wave device according to claim 1 or 2, wherein the reflection surface and the proximal end surface are arranged in such a positional relationship that the shear waves generated at the reflection surface converge at the focal point from both sides in a direction orthogonal to the proximal end surface.

9. The surface acoustic wave device according to claim 1 or 2, further comprising a vibration absorber provided at a distal end portion of the surface wave generation section in the propagation direction of the surface acoustic wave.

10. The surface acoustic wave device according to claim 1 or 2, wherein
the reflection section has an annular shape,
the ultrasonic wave source is disposed annularly along the reflection section, and
the target surface is disposed on an inner side relative to an inner periphery of the reflection section.
